# EUROPEAN PATENT APPLICATION

(11) **EP 3 467 878 A1**
(43) Date of publication of application: **10.04.2019**
(21) Application number: 17757785.5
(22) Date of filing: 02.06.2017
(51) Int. Cl.: H01L 31/02, H01L 31/0224, H01L 31/0687, H01L 31/18

(54) **PHOTOVOLTAIC CELL, PHOTOVOLTAIC PANEL AND METHOD FOR THE PRODUCTION OF PHOTOVOLTAIC CELLS**

(30) Priority: 03.06.2016 ES 201630751
(71) Applicant: Universidad del Pais Vasco - Euskal Herriko Unibertsitatea (UPV/EHU), 48940 Leioa (ES); Universidad Politécnica de Madrid, 28040 Madrid (ES)
(72) Inventor: JIMENO CUESTA, Juan Carlos, 48940 Vizcaya - Leioa (ES); GUTIÉRREZ SERRANO, José Rubén, 48940 Vizcaya - Leioa (ES); FANO LESTÓN, Vanesa, 48940 Vizcaya - Leioa (ES); DEL CAÑIZO NADAL, Carlos, 28040 Madrid (ES)
(74) Representative: Balder IP Law, S.L.
(86) International application number: PCT/ES2017/070401
(87) International publication number: WO 2017/207860

(57) **Abstract**

A photovoltaic cell (Cᵢ) comprising at least one sub-cell of a first semiconductor (1) and a sub-cell of a second semiconductor (2) connected by means of three electrodes (T1, T2, T3). The second semiconductor is typically silicon, while the first semiconductor is a material with wider band-gap deposited closer to a surface of incidence of electromagnetic radiation. The first electrode (T1) is on the forward face of the photovoltaic cell (Cᵢ), while the second electrode (T2) and the third electrode (T3) are on the rear face of said photovoltaic cell (Cᵢ). Both the second electrode (T2) and the third electrode (T3) are connected to the second semiconductor (2). The regions on both sides of the area of contact between the first semiconductor and the second semiconductor have the same type of majority carriers. Thus, a photovoltaic cell (Cᵢ) is achieved with a high conversion efficiency that is capable of being integrated into devices with two terminals.

## Description

### Object of the invention

The present invention relates to the photovoltaic solar energy field, and more specifically to a tandem-type photovoltaic cell.

### Background of the invention

Crystalline silicon solar cells currently dominate the photovoltaic sector, due to a reasonable conversion efficiency, good temporal stability and a manufacturing technology that is simple, cheap, stable and respectful of the environment. Although the silicon photovoltaic cells that are used most commonly have efficiencies of between 18% and 19%, there are industrial products that reach values around 24%, which is very close to the theoretical limits calculated for this technology. It is therefore necessary to find technological solutions that enable the threshold limits of this type of cells to be exceeded.

The main alternative for raising the efficiency of the photovoltaic cells are tandem cells, which comprise a plurality of layers (also called 'sub-cells' or 'levels') made out of different semiconducting materials. Selecting materials with different widths of forbidden band (from the English "band-gap") achieves the sensitization of the cell to the various spectral ranges of the photons comprised in the solar radiation. As such, the materials with a wider band-gap absorb the more energetic photons, with short wavelengths, but they are able to operate at high voltages. On the other hand, the materials with a narrower band-gap are less selective with respect to the wavelength of the photons, but their operation voltage is also lower. In every case, the current photogenerated or obtained by means of the absorption of photons is proportional and close to the flow of absorbed photons. In order to maximize the efficiency of the conversion of light to electricity when using multiple sub-cells, it is necessary to direct the most energetic photons to the sub-cells with a wider band-gap, which are able to absorb them and deliver electrical current at elevated voltages, while the photons with less energy are directed towards cells with a narrower band-gap, which are able to absorb them even while operating at lower voltages. Given that the materials with a wider band-gap are transparent to the less energetic photons, said materials can directly face the sunlight, in order to subsequently place other materials that are sensitive to the unabsorbed materials behind them.

The tandem cells are usually associated in series at an electrical level, in other words, the current that pass through each sub-cell is identical, the total voltage being the sum of the voltages that each sub-cell contributes. The resulting devices are simple to use, since they have only two electrical terminals, one in the its front face, facing the sunlight and the other in the opposite face, generally covering the entire rear surface of the device. However, the implementation of this configuration brings with it a notable complexity. Let's consider a typical case based on three semiconductors, the sensitivity of which to the solar spectrum mainly covers the ultraviolet (UV), visible (VIS) and infrared (IR) ranges, respectively. The junctions between the layered structure could be implemented following pn_{UV}-pn_{VIS}-pn_{IR} type junctions. Nevertheless, this implies the appearance of a parasite n-p junction between each layer, which is capable of developing an opposing voltage to that obtained by the pn device that is being sought. In order to prevent this, it is necessary to construct another intermediary device between each sub-cell, of the type n⁺⁺p⁺⁺ wherein the ++ index indicates that it is a semiconductor doped to the point that it is degenerated with respect to the predominant gas thereof. This intermediary device, called a tunnel diode, enables the sub-cells to be interconnected without significant voltages appearing in the opposite direction to those desired.

Additionally, each layer should enable the passage of non-absorbed photons for their conversion in subsequent layers, for which reason the semiconductors should be chosen carefully in order for the dielectric constants thereof to be as similar as possible. Finally, given that the series configuration implies that the current should stay constant throughout all the layers, said current is limited to the current photogenerated by the layer that imposes the minimum value thereof. Therefore, it is necessary to carefully choose not only the material of each layer but also the thickness thereof such that a reduced capturing of photons does not limit the total current of the device, or even that an excessive capturing thereof leaves the next layer in a situation where there is a lack of available photons.

The tandem cells can be made of two, three, four or more levels, although after four levels, there do not seem to be expected notable improvements in the efficiency of the device. For the specific case of a tandem cell with three levels in series based on semiconductors III-V of the gallium arsenide family, efficiencies to the order of 40% were obtained. Nevertheless, said implementations have an elevated cost due to the need to use germanium substrates. Said cost has prevented the generalized use thereof, staying restricted to photovoltaic systems of high concentration and to space applications, in which the prime efficiency exceeds the cost. These devices tend to require almost twenty layers in order to implement the three sub-cells, the intermediary tunnel diodes and other necessary interface layers.

In the case of tandem cells in which one of the visible or ultraviolet layers is a crystalline silicon sub-cell, none of the known solutions in the state of the art have been able to provide efficiencies greater than those of a simple cell made of the same material. This is due in the first place to that fact that it is not possible to find a material with a small band-gap width capable of reaching the results of the silicon sub-cells, therefore limiting the intensity that can be obtained by a series system. In the infrared portion of the solar spectrum that cannot be absorbed by the silicon, there are enough photons for only 26 mA/cm² of device exposed to the light under a normalized irradiance of 1 sol and spectrum AM1.5G. These photons are insufficient for improving a silicon cell that can generate up to 44 mA/cm² using the visible and ultraviolet portions of the solar spectrum. Even in the case of using three-layer structures, in which the silicon sub-cell were the layer corresponding to visible, carrying out an efficient distribution of those 44 mA/cm² of the original silicon cell between two ultraviolet and infrared sub-cells is complex without limiting the scarce available photons for the infrared sub-cell. Furthermore, the infrared sub-cell is subject to losses from reflection in the interface thereof with the upper silicon sub-cell and to losses from transmission of the photons of the most far infrared. Thus, it is not viable to have a tandem structure with series connection that combines a silicon sub-cell and a sub-cell with band-gap width.

In the case of tandem cells with a silicon sub-cell acting as a collector of the infrared region, it is possible to obtain very efficient cells, even using only two layers. For the case of a tandem solar cell with two layers with electric series connection, the infrared sub-cell being a silicon sub-cell with 25% efficiency, this structure enables a theoretical efficiency of up to 37% to be obtained using a material with a band-gap width of 1.75 eV for the ultraviolet sub-cell. There would also be a net efficiency gain for a range of materials with band-gap widths comprised between 1.6 and 2.0 eV. However, this structure is very sensitive to the width of the band-gap of the material used for the other sub-cell (ultraviolet sub-cell), the efficiency of the silicon sub-cell being affected by the fact that another ultraviolet cell is implemented over it, limiting the range of usable materials. To this end, S. Essig (6th International Conference on Crystalline Silicon Photovoltaics, March 2016, Chambery, France) recently presented a tandem cell with 29.8% efficiency, which is considered a world record, in which the cells were created independently and then stacked mechanically. The final device had four terminals, with two independent circuits, presenting, therefore, an elevated complexity, in both manufacturing and use.

The patent document US 5322572 B2 presents a structure with two main InP and GaInAsP sub-cells, respectively connected by means of three electrodes: a rear contact, an assembly of upper contacts joined to the InP sub-cells and an assembly of intermediary contacts joined to both sub-cells and accessible from the outer face of the cell. Therefore, the device only has two active layers, using silicon derivatives for auxiliary functions that are not related to the conversion of solar radiation.

In a second example, the patent document US 8088991 B2 presents a photovoltaic cell with two sub-cells of distinct materials, there being the possibility of including silicon sub-cells. The device likewise comprises three terminals, two of them located in the outer face of the cell and one of them in the inner face thereof. The device has a series configuration, but comprises external elements that establish the current that circulates between the terminals, with the goal of preventing the current limitations of the layer with the least absorption and maximize the power. Said external element can be, for example, a DC/DC converter for maximum power point tracking (MPPT). The interfaces between materials are made between layers with the same type of conductivity.

In a third example, in the patent document US 2003/0015700 A2 a photovoltaic cell is presented with multiple sub-cells of monolithic crystalline materials, it being possible to include silicone. For the monolithic integration of the junctions between materials, accommodation buffers are incorporated by means of high-quality monocrystalline oxides. The device comprises three contacts, two of them being located on the outer face thereof and a series structure of the sub-cells being established.

Likewise, alternative tandem structures to series connection are known. Particularly, tandem cells can be implemented by connecting multiple sub-cells of the same material in series inside each layer. Then, all the layers are connected to each other in parallel. In the case that the operation voltage of the sub-cells of each layer is the result of multiplying or dividing by two the operation voltage of the cells in the adjacent layers, a simple structure is obtained, with only two electrical terminals, which may be interconnected in a solar panel such as a conventional solar cell.

For example, patent document EP 2490267 A2 shows a tandem cell with layers connected in parallel, and one of these layers comprising a crystalline silicon sub-cell. Contrary to the series connection, this structure enables the silicon sub-cell to be used as an ultraviolet sub-cell, by using multiple sub-cells in series of another material as an infrared capturing layer. Alternatively, the same structure of layers connected in parallel enables the silicon sub-cell to be used to capture infrared, similar efficiencies being obtained to that of the tandem cells in series, but with a lower sensitivity of the efficiency with respect to the material used. As a result, the sensitivity to alterations of the solar spectrum with which the cell is illuminated is also minimized. However, if the extension of this structure to a topology of three layers is desired in order to move closer to the theoretical limits (around 40%), it would be necessary to implement seven sub-cells in each cell: one for the ultraviolet layer, two for the visible layer and four for the infrared layer. Therefore, said implementation complexity is excessive for current photovoltaic panels.

As for the patent document US 4948436 B2, it presents a tandem cell with layers connected in parallel that may include amorphous silicon or microcrystalline sub-cells. Each sub-cell comprises a p-i-n structure, the neighboring sub-cells being connected through regions with the same type of conductivity (p-o-n). Thus, a modular structure is achieved with two electrodes that enable multiple tandem cells to be connected in series. The device can likewise comprise grooves to separate the multiple cells. However, the device has, among others, the aforementioned limitations regarding the conversion efficiency thereof and its extension to topologies with three layers.

Lastly, document US 2010/0263713 A1 presents a photovoltaic cell that incorporates three materials connected in parallel, it being possible to include silicon. The device comprises four contacts: a first contact electrically connected to a second region of the first material, a second contact connected to a first region of the first material, a third contact connected to a first region of the second material and a fourth contact connected to the third material. All the contacts, with the exception of the third, are accessible from the rear portion of the device, comprising slots with different depths in order to reach the materials described. The device covers outer dielectric and inverter layers in order to control voltages and the adaptation of the system with four contacts to solar panels with two contacts.

However, there is still the need in the state of the art for a tandem photovoltaic cell that is compatible with crystalline silicon sub-cells that overcome the limitations described with regards to the maximum conversion efficiency, without significantly increasing the complexity of the devices and the manufacturing process thereof. In addition, it is desirable for said photovoltaic cell to avoid tunnel diodes and any external element for conditioning signals for the connection thereof to conventional solar panels with two terminals. Likewise, it is desirable for all metallizations of the cell to be carried out in the same technological step, and that the metal coatings of the front face have the smallest area possible.

### Description of the invention

The present invention resolves the aforementioned problems by means of a tandem-type photovoltaic cell with electrical associations in series of the sub-cells of each layer and the layers in parallel to each other, and with junctions between layers through regions that share the same type of conductivity.

In a first aspect of the invention, a photovoltaic cell comprising sub-cells of at least two semiconductor materials is presented.
- A first semiconductor, with a wider band-gap width and closer to the surface of incidence of the electromagnetic radiation to be converted, which typically converts solar radiation with lower wavelengths, generally focused on the ultraviolet wavelength, of energies typically greater than 1.4 eV.
- A second semiconductor, with a narrower band-gap width and further from the surface of incidence of the radiation than the first semiconductor. The second semiconductor is preferably crystalline silicon, although any of those used as a visible cell in tandem structure or as an individual cell may be use, such as amorphous silicon or cadmium telluride or chalcopyrites of the type used in cells known as CIGS or even used in tandem cells of III-V materials, such as gallium arsenide or gallium and aluminum arsenide and others. However, in the present invention the second sub-cell must have a structure with rear contacts and although it is technologically possible to carry this out in the mentioned materials, they are currently only carried out and commercialized in silicon cells, due to the insufficient diffusion length of the minority carriers of some of the materials mentioned or the technological complexity in order to outline the rear face of the device, which is properly resolved in the case of silicon cells. This second semiconductor may operate by absorbing the solar radiation with wavelengths focused on the visible and/or infrared wavelength depending on the number of layers of the device.
- In some embodiments there is also a third semiconductor, with a narrower band-gap width and further from the surface of incidence of the radiation than the first semiconductor. The third semiconductor is integrated in at least two sub-cells connected in series to each other, and in parallel to the second semiconductor. The third semiconductor typically converts solar radiation with wavelengths focused on the infrared wavelength beyond the radiation that can be absorbed by the second semiconductor, which in the case of being implemented in silicon takes place for light wavelengths greater than 1.1 micrometers. For said range of lengths greater than 1.1 micrometers, the solar spectrum includes photons that are capable of generating photocurrents close to 26 mA/cm² with an energy density that constitutes 20% of the total energy of the complete spectrum. However, the limitation imposed by this invention that the sub-cells of this third semiconductor work at half the voltage of the second sub-cell, of silicon, limits the maximum current that can be extracted at half and the net efficiency increase due to this third semiconductor may be to the order of 3%, which constitutes a value close to 10% of the total energy supplied by the complete device.

The first semiconductor and the second semiconductor define a first interface between them. The semiconductor materials on both sides of this first interface comprise, in the region closest to said first interface, the same type of majority carriers (i.e. the same type of conductivity between p-type or n-type). Similarly, in the embodiments in which a third semiconductor is used, the semiconductor materials on both sides of a second interface between the second semiconductor and the third semiconductor comprise, in the region closest to said second interface, the same type of majority carriers, which may or may not coincide with the type of majority carriers of the first interface.

Likewise, the photovoltaic cell comprises three electrical terminals or electrodes through which the electric energy generated by converting the photons of the incident electromagnetic radiation is extracted:
- A first electrode, connected to the first semiconductor on an end opposite the first interface, i.e. on a face of the first semiconductor closest to the surface of incidence of the light.
- A second electrode, connected to the second semiconductor and said electrode being accessible from an end opposite the surface of electromagnetic radiation. That is to say, the second electrode extends, at least partially, to an electrical contact in the rear portion of the photovoltaic cell.
- A third electrode, connected to the first semiconductor and the second semiconductor, said electrode being accessible from an end opposite the surface of electromagnetic radiation. That is to say, the third electrode extends, at least partially, to an electrical contact in the rear portion of the photovoltaic cell.

In the case of a cell that includes the third semiconductor, the second electrode and the third electrode are connected to opposite ends of the sub-cells of said third semiconductor. The combination of connections in series of the sub-cell of a layer and of connection in parallel between layers, joined to interfaces with the same type of majority carrier and the positioning of the electrodes, enables high efficiency tandem photovoltaic cells that are compatible with silicon to be implemented without increasing the complexity of the manufacturing thereof.

The voltages at which the layers of the different semiconductors operate may operate in accordance with two preferred options:
- The voltage between the first electrode and the third electrode is twice the magnitude of the voltage between the second electrode and the third electrode. That is to say, the outermost layer operates at twice the voltage of the other two layers, advantageously enabling the connection thereof to photovoltaic panels with two terminals.
- The voltage between the first electrode and the third electrode is of the same magnitude and opposite sign as the voltage between the second electrode and the third electrode. That is to say, the three layers seemingly operate at the same voltage. However, similarly to the previous case, the sub-cell of the first semiconductors works at twice the voltage of the second semiconductor and this one, in turn, at twice the voltage of each of those of the third semiconductor. Internally, the connection between the sub-cells of the first and second semiconductor is made through a floating emitter of the latter, which is capable of maintaining the voltage excess on the base terminal or substrate of the sub-cell of the second semiconductor. In this option, the second terminal adopts the function of reference terminal, despite not coinciding with the base or substrate of the sub-cell of the second semiconductor. In this way, the voltage between the first electrode and the second electrode is twice the magnitude of the voltage between the third electrode and the second electrode, similarly enabling the connection thereof to photovoltaic panels with two terminals. This second option has an equivalent electrical circuit that is more complex and it is harder to understand; however, it has some advantages regarding implementation, since in the case that the base or substrate material of the second semiconductor, silicon in a preferred embodiment, is of the n-type, which is common in silicon cells with rear contacts and high efficiency, the outer or front face of the first semiconductor may be of the n-type, which prevents, in many cases, having to resort to outer conducting and transparent layers to extract the current from the first electrode, due to greater electron mobility that provides holes for the majority of semiconductor materials.

In a second aspect of the present invention, a photovoltaic panel comprising a plurality of photovoltaic cells according to any of the preferred configurations and options and particular embodiments described for the first aspect of the present invention is presented. That is to say, the photovoltaic panel comprises a plurality of cells with two or three layers of semiconductor materials with connections in series between sub-cells of a layer (in the case of there being layers with multiple sub-cells) and connections in parallel between layers, interfaces with a same type of majority carrier on both sides, and two electrodes located in the rear portion of each cell. The photovoltaic panel likewise comprises the means of interconnection between cells, being able to form modules from the so-called flat modules.

Given that the first semiconductor material of each cell operates at twice the voltage of the second semiconductor material, the integration thereof is possible in modules with only two electrical terminals. In particular, the second electrode of each cell is connected to the first electrode of a first adjacent cell and to the third electrode of a second adjacent cell. Preferably, the described interconnections are implemented by means of two conducting layers separated by an insulating layer. More preferably, each conducting layer comprises a plurality of tiles (in other words, of mainly flat connection elements), each tile partially or completely covering a surface occupied by two adjacent cells.

Lastly, in a third aspect of the invention, a manufacturing method of photovoltaic cells according to any of the preferred configurations and options and particular embodiments described for the first aspect of the present invention is presented. The method comprises, at least, the following steps:
i. Epitaxially growing or depositing or by some method that creates crystalline layers (such as growth at a sufficient temperature for chemical vapor deposition, or CVD), at least the first semiconductor over the second semiconductor, which acts as a substrate for the entire device, and wherein the first semiconductor has a wider band-gap width than the second semiconductor.
ii. In some embodiments, epitaxially growing or depositing or by some method that creates crystalline layers (such as growth at a sufficient temperature for chemical vapor deposition, or CVD), at least the third semiconductor over the second semiconductor, on a face opposite the deposition face of the first semiconductor, and the third semiconductor having a narrower band-gap width than the second semiconductor.
iii. Forming, typically by means of metallization, a first electrode connected to the first semiconductor at an end opposite a first interface between the first semiconductor and the second semiconductor.
iv. Forming, typically by means of metallization, a second electrode connected to the first semiconductor and to the second semiconductor, the second electrode being accessible from an end opposite the surface of incidence of electromagnetic radiation.
v. Forming, typically by means of metallization, a third electrode connected to the second semiconductor and accessible from the end opposite the surface of incidence of electromagnetic radiation

The cell, panel and method described therefore provide a technology capable of reaching high conversion efficiencies (to the order of 39-40%), that is easy to manufacture, and compatible with crystalline silicon sub-cells. Furthermore, tunnel diodes are avoided, as well as external elements for conditioning signals for connection to conventional solar panels with two terminals. Likewise, all the metallizations of the cell can be carried out in one technological step, simplifying the manufacturing of the devices. The technologically reachable efficiency with this device is estimated to be 39.5%, much higher than the 25% obtainable by the current solar cells based on silicon. These efficiency values are possible due to the existence of diverse electrical circuits from which the electrons can be extracted from the semiconductors that comprise the device at different voltage levels: two different voltage levels when the two semiconductor materials are used and three when three semiconductors are used. The electrical circuit with greater voltage is where the electrons circulate, the energy of which comes from the most energetic photons and in the same way the electrical circuit with less voltage corresponds to the electrons with energy coming mostly from the least energetic photons.

Lastly, the first electrode can contribute a higher operation voltage with respect to the reference electrode, third or second electrode, depending on the case, than the remaining electrode, but the output current of said first electrode is essentially lower. This property makes it possible for the metal coatings of the front face to be very small, smaller even than those of a conventional solar cell. In the case of the structures with three or more terminals known in the state of the art, the currents to be extracted by the front face of the device are always greater, forcing greater metal coatings.

The different aspects and embodiments of the invention defined in the previous paragraphs can be combined together, provided that they are compatible.

These and other advantages of the invention will become apparent in the light of its detailed description.

### Description of the drawings

In order to assist in a better understanding of the characteristics of the invention according to a preferred exemplary embodiment thereof, and to complement this description, the following figures, of illustrative and non-limiting nature, are attached:
Figure 1 shows the electrical circuit equivalent to an example of a tandem cell with three levels of connection in series according to the state of the art.
Figure 2 shows the electrical circuit equivalent to an example of a tandem cell with three levels of connection in parallel according to the state of the art.
Figure 3 shows the electrical circuit equivalent to an example of a tandem cell with three levels according to the state of the art, wherein the sub-cells of each level operate at a voltage twice that of those of the following level.
Figure 4 shows the structure of a tandem-type photovoltaic cell with three levels and three terminals, according to a first embodiment of the present invention.
Figure 5 shows the equivalent electrical circuit of said first embodiment.
Figure 6 shows the structure of a tandem-type photovoltaic cell with three levels and three terminals, according to a second embodiment of the present invention.
Figure 7 shows the equivalent electrical circuit of said second embodiment.
Figure 8 shows the structure of a tandem-type photovoltaic cell with two levels and three terminals, according to a third embodiment of the present invention.
Figure 9 shows the equivalent electrical circuit of said third embodiment.
Figure 10 shows the structure of a tandem-type photovoltaic cell with two levels and three terminals, according to a fourth embodiment of the present invention.
Figure 11 shows the equivalent electrical circuit of said fourth embodiment.
Figure 12 shows the structure of a photovoltaic cell with permeable and selective membranes with respect to the current carriers, according to a fifth embodiment of the present invention.
Figure 13 shows the equivalent electrical circuit of said fifth embodiment.
Figure 14 presents a forward front view of a photovoltaic solar cell, according to any of the five previous embodiments of the present invention. In the figure three current extraction bars or bus bars are represented although this number can be variable or even not exist.
Figure 15 presents a rear front view of a photovoltaic solar cell, according to any of the five previous embodiments of the present invention.
Figure 16 illustrates the schematic representation used for the descriptions of the connection between cells of the present invention, considering the electrode T3 as reference terminal (even though, depending on the embodiment, said reference electrode can be the one called T2 or T3).
Figure 17 schematically shows the interconnection between cells of a photovoltaic panel according to a sixth possible embodiment of the present invention, enabling cells with three terminals to be integrated in solar panels with two terminals.
Figure 18 presents in greater detail the interconnection between cells by means of two conduction planes, according to said sixth preferred embodiment.
Figures 19a, 19b and 19c present, respectively, the forward, lateral and rear views of the system of conduction planes of said sixth preferred embodiment.
Figure 20 shows a detail of a practical implementation of the laminated assembly used in said sixth preferred embodiment.
Figure 21 shows a manufacturing diagram of a photovoltaic cell according to a preferred embodiment of the manufacturing method of the invention.

### Preferred embodiment of the invention

For clarity, in the present description, "upper", "forward" and "front" are used for the region of the device that is closest to the surface of incidence of the electromagnetic radiation to be converted. In the same way, "lower" and "rear" are used for the region of the device that is opposite the surface of incidence of the electromagnetic radiation to be converted.

Likewise, in the present description "ultraviolet layer", "ultraviolet sub-cell", etc., are used to refer to the layer/sub-cell/etc. implemented with the first semiconductor, with a wider band-gap, and, therefore, responsible for converting the photons with a shorter wavelength. Nevertheless, said nomenclature should be interpreted as a relative notation in order to distinguish the different elements of the cell and not as a limitation of the exact range of wavelengths absorbed by said elements, which is determined by the properties of the particular material chosen as first semiconductor in each implementation. Likewise, in the present description "visible layer", "visible sub-cell", etc., is used to refer to the layer/sub-cell/etc. implemented with the second semiconductor, with intermediate band-gap width; and "infrared layer", "infrared sub-cell", etc. is used to refer to the layer/sub-cell/etc. implemented with the third semiconductor, with a narrower band-gap width; being applicable *mutatis mutandis,* the same considerations on the explained nomenclature for the term "ultraviolet".

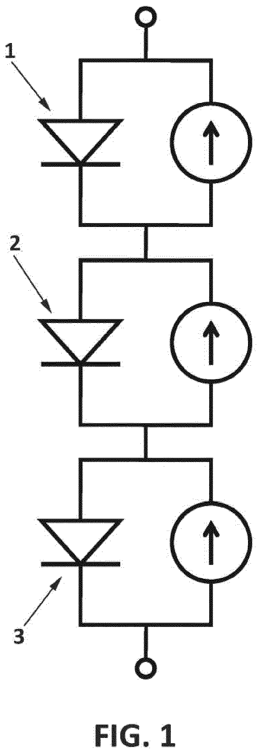

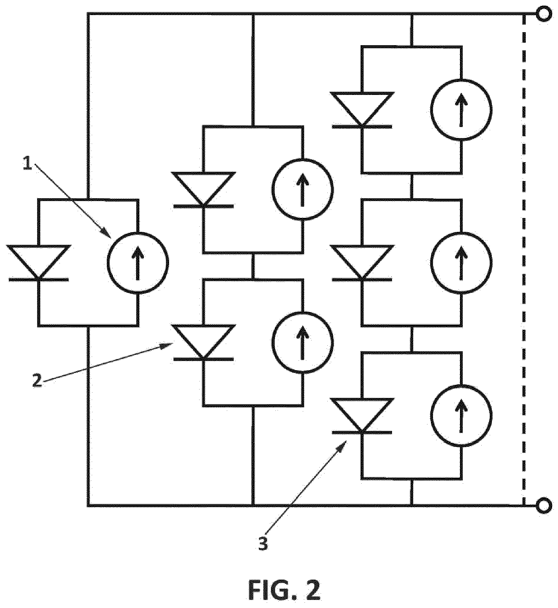

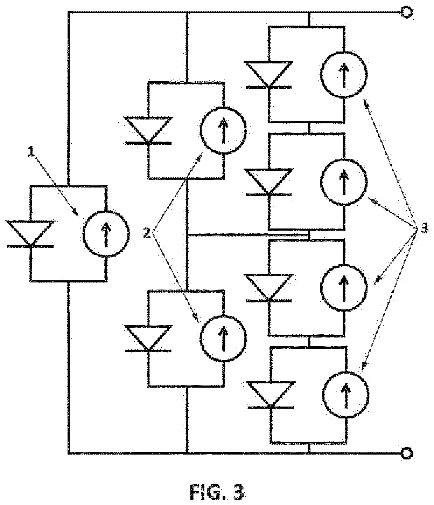

Figures 1, 2 and 3 present the electrical equivalents of configurations known in the state of the art for photovoltaic cells with three semiconductor materials, in other words, with at least one ultraviolet sub-cell 1, at least one visible sub-cell 2 and at least one infrared sub-cell 3. In particular, figure 1 presents a connection in series between sub-cells, the conversion efficiency of which is hampered by the intensity limit generated by the infrared sub-cell 3. Figure 2 presents a general tandem cell with connections in parallel, while figure 3 presents a tandem cell in which the sub-cells of each layer operate at half the voltage of the sub-cells of the layer immediately above it, facilitating the integration thereof in solar modules with two terminals. In both cases, a large number of sub-cells are needed in order to implement each cell, with the resulting manufacturing complexity and with a possible reduction in efficiency due to the manufacturing deviations and the effects of depositing each layer on top of the previous ones.

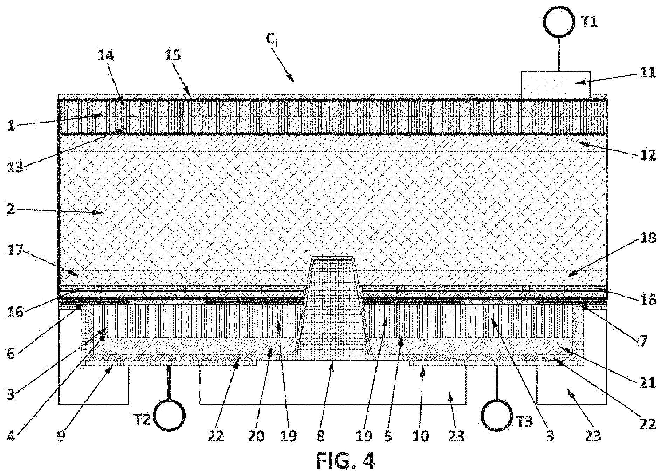

With regards to the limitations of the configurations known in the state of the art, figure 4 presents a first preferred embodiment of the photovoltaic cell Cᵢ of the invention, comprising an ultraviolet sub-cell 1, a visible sub-cell 2 and two infrared sub-cells 3. The visible sub-cell 2 is preferably implemented in crystalline silicon, the ultraviolet sub-cell 1 is implemented in a material with a greater band-gap width than that of the visible sub-cell 2, typically between 1.5 eV and 2.5 eV, and the infrared sub-cell 3 is implemented in a material with a narrower band-gap width than that of the visible sub-cell 2, typically between 0.6 and 0.9 eV. The ultraviolet cell is the closest to the incidence of the electromagnetic radiation, absorbing the most energetic photons thereof and being invisible to the rest, which move on to the rear layers.

For example, the ultraviolet sub-cell 1 can be implemented in crystalline silicon carbide or gallium phosphide or in semiconductors from the ZnIVN₂ family; and the infrared sub-cell 3 can be implemented in silicon-germanium. Nevertheless, it must be noted that the topology described for the photovoltaic cell of the invention is compatible with other combinations of materials known in the state of the art for general tandem cells. It must likewise be noted that in the case of cells with two levels, the crystalline silicon can adopt the function of ultraviolet sub-cell 1 as well as that of infrared sub-cell 3.

The photovoltaic cell Cᵢ likewise comprises three terminals or electronic electrodes: a first electrode T1 electrically connected to the ultraviolet sub-cell 1 through a first electrical contact 11; a second electrode T2 or positive electrode electrically connected to the visible sub-cell 2 and one of the infrared sub-cells 3 through a second electrical contact 9; and a third electrode T3, also referred to as negative electrode or reference electrode, connected to the three sub-cell layers through a third electrical contact 10.

Given that the operation voltage of each infrared sub-cell 3 is less than the operation voltage of the visible sub-cell 2, the infrared layer comprises multiple sub-cells connected in series. In the particular case of the two sub-cells of figure 4, a first infrared sub-cell 4, upon being arranged in contact with the second electrode T2, has polarity p⁺-p/n-n⁺, while a second infrared sub-cell 5, upon being arranged in contact with the third electrode T3, has polarity n⁺-n/p-p⁺. Both can share the p⁺ electrode 6 and the n⁺ electrode 7 with the visible sub-cell 2. The interconnection in series between the first infrared sub-cell 4 and the second infrared sub-cell 5 is carried out with a simple connection 8 of the outermost electrodes thereof, using a metal or other conducting material to do so.

It must be noted that the second electrode T2 and the third electrode T3 are accessible from the rear face of the photovoltaic cell Cᵢ. Therefore, one of the advantages of the proposed structure is that all the subsequent metallizations can be carried out in the same technological step, including the second electrode T2, the second electrical contact 9, the third electrode T3, the third electrical contact 10, and the connection 8.

A differentiating property of the proposed structure is that all the interfaces between different sub-cells are carried out using materials of the same electronic type for each sub-cell on the sides of the interface. That is to say, the p-type outer surfaces of the visible sub-cell 2 always connect with p-type surfaces for both infrared sub-cells 3 and ultraviolet sub-cells 1. In the same way, the n-type outer surfaces of the visible sub-cell 2 can house upper or lower cells with an n-type surface in the contact surface thereof with the visible sub-cell 2. In this way, all the contacts between sub-cells are ohmic and the access to all the inner terminals of the ultraviolet sub-cells 1 and the infrared sub-cells 3 can be carried out from the visible cell 2. Upon carrying out all the transitions between cells through regions of the same type (p-p or n-n), all the planes in which the concentrations of both carriers are similar (p≈n) are located in the inner region of each material, far from the transitions between sub-cells, which notably reduces the recombination of carriers and makes greater efficiency possible.

For a photovoltaic cell Ci, the substrate material of which (in other words, the material of the visible sub-cell 2) is n-type, like the one represented in figure 4, the front surface can be passivized by means of an n-type passivating layer 12. In this case, the ultraviolet sub-cell 1 should have a lower surface 13 in contact with the n-type visible sub-cell 2. Given that the ultraviolet sub-cell 1 is made of a material with a wider band-gap width than that of the visible sub-cell 2, the intrinsic carrier concentration thereof typically has a very small value compared to that of the material of the visible sub-cell 2, for which reason said material with a high band-gap value can act as the passivator. In this case, the passivating layer 12 can be omitted.

Following the case of using an n-type semiconductor as a substrate material, the upper surface 14 of the ultraviolet sub-cell 1 must be p-type. Given that the majority of materials have very low hole mobilities and the thickness of the ultraviolet layer is small, it is possible that the associated series resistance thereof is high and cannot serve by itself to adequately extract all the current towards the first electrode T1. In this case, apart from the first contact 11, a conductive layer 15 can be included covering the front surface of the device and having an elevated transparency to the entire useful photon spectrum for the cell. Said conducting layer can be made, for example, of indium tin oxide (ITO) or other transparent conducting oxides (TCO). Alternatively, the conducting layer 15 can be made by means of graphene, which further fulfills the double function of passivating the upper surface 14 of the ultraviolet sub-cell 1 while improving the current extraction upon reducing the associated series resistance.

The photovoltaic cell preferably comprises at least a first selective membrane 16 with transportation by tunnel effect that substitutes the p-n junctions. Said first selective membrane 16 is a dielectric with sufficiently small thickness to be able to be passed through by the current carriers by means of tunnel effect. These barriers can be selective with respect to the electrons or with respect to the holes. For one of said current carriers to be able to pass through them it is necessary for there not to be a noticeable jump from the energy of the carrier on both sides of the barrier, in other words, for the energetic position that an electron or hole occupies in the origin material, it is necessary for there to be the same energetic level enabled in the destination material. The probability of transit is a function of both the thickness of the dielectric to be passed through and the necessary change in the crystalline impulsion of the carrier on both sides of the barrier, for which reason the band structure of the origin and destination materials intervene in the current transportation mechanism. Using materials with different band-gap widths as carrier origin and destination materials, or even with identical band-gap widths but slightly displaced in energies on both sides of the dielectric material, it is possible to make it so only one of the carriers can pass through it, using this quality for the construction of membranes permeable to only one type of carrier. The thickness of the dielectric layer, which is critical for an acceptable current circulation, must be less than or equal to 20 angstroms. A typical material that can be used is silicon oxide, which in small thicknesses crystallizes in the shape of cristobalite and creates a structure with minimum dimensions of 16 angstroms suitable for this purpose.

The first selective membrane 16 is placed in the rear portion of the visible sub-cell 2. After this oxide, regions of material (p⁺ electrode 6 and n⁺ electrode 7) are selectively deposited, the functions extraction operation of which guarantee that p-type 17 or n-type 18 regions are induced in the base region of the visible sub-cell 2 covered by the first selective membrane 16. It is also possible to carry out an equivalent structure without the need to implement the dielectric layers, and carrying out the p-type 17 or n-type 18 regions in the base region of the visible sub-cell 2 by means of impurity diffusion. Nevertheless, the efficiency of this structure will be lower due to the high recombination that implies the continuity thereof to the semiconductor with narrower band-gap width 19, without the existence of an intermediary passivating layer, mission which is well covered by the membrane 16. The band structure of the deposited layers allows for the transition of holes through the p⁺ electrode 6 by the tunnel effect. In the same way, the n⁺ electrode 7 that induces n-type regions 18 has a band structure that makes the transit of electrons possible between said n⁺ electrode 7 and the visible sub-cell 2. Preferably, the regions of the p⁺ 6 and n⁺ 7 electrodes are constituted by p-type and n-type doped polysilicon, respectively. These polysilicon layers can act at the same time as emitter regions of the infrared sub-cells 3. These infrared sub-cells 3 can have the base regions 19 thereof of the same type and doping, such that they can be carried out in the same technological process. Subsequently, the rear emitters 20 and 21 of both infrared sub-cells 3 are deposited, having different electronic types for each one of them. Before carrying out the electrical contacts of the rear face 8, 9 and 10 that constitute both the outer electrodes T2 and T3 and the interconnection between the two infrared sub-cells 3, it is necessary to grow or deposit an insulating layer 22 that prevents these infrared sub-cells from short circuiting.

The selective membranes by tunnel effect can also be used in the ultraviolet sub-cell 1. In this case, the ultraviolet sub-cell 1 needs a region where the carriers created by high-energy photons can remain during a period of time that is sufficient in order to be extracted before being reincorporated into the low energy level situation. A p-type region of a material with a high width of the band-gap is enough to store high-energy electrons, in the case of these being the carriers that are intended to be extracted. In the case of being the holes, an n-type region is used. The doping in this region must be gradually varied, there being a greater concentration in the area closest to the interface with the visible sub-cell 2 and less doping on the surface of the cell, such that the accumulated electrons prefer to accumulate close to the front surface of the device.

In order to facilitate the connection of these contacts to the outer circuit, the rear surface of the photovoltaic cell Cᵢ may be partially covered by an insulating layer 23. This insulating layer 23 only leaves the contact area of the second electrode T2 and the third electrode T3 exposed, facilitating the interconnection to the outer circuit that may be carried out by means of the selective application of a conducting material, for example, by means of screen printing.

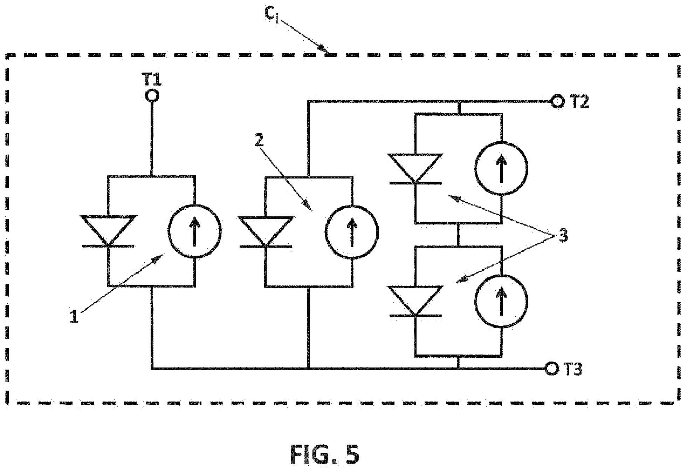

Figure 5 shows the equivalent electrical circuit linked to the first preferred embodiment of the photovoltaic cell Ci, represented in figure 4. It must be noted that the visible sub-cell 2 operates at a voltage V, the ultraviolet sub-cell 1 operates at a voltage 2V and each infrared sub-cell 3 operates at a voltage 0.5V.

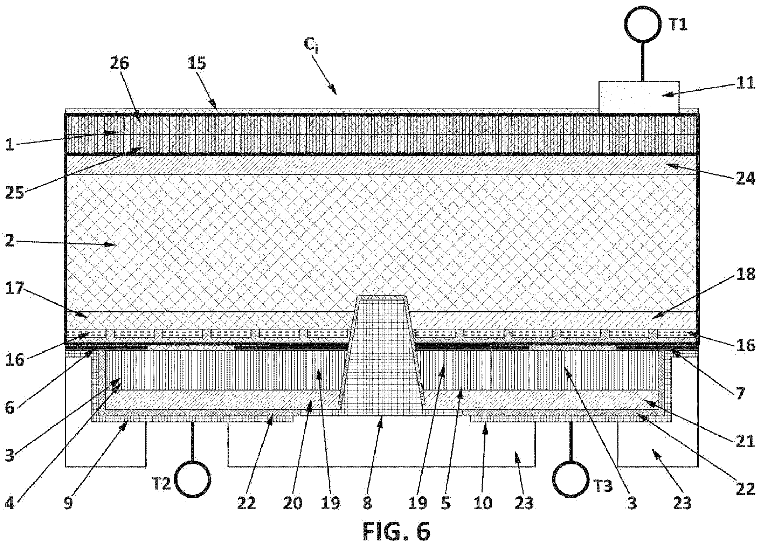

In the case where a first n-type contact 11 is needed instead of a p-type, either taking into account current extraction reasons or other technological reasons, a structure equivalent to that of figure 4 may be carried out, substituting the p-type regions for n-type regions and vice versa. Alternatively, the aforementioned distribution of the regions (second n-type semiconductor) can be maintained and a p-type floating emitter 24 located in the front portion of the visible sub-cell 2 can be added, as shown in the second preferred embodiment of the cell of the invention shown in figure 6. In this case, the central p-type region 25 of the ultraviolet sub-cell contacts the front surface of the visible sub-cell 2, while the n-type region 26 of this ultraviolet sub-cell constitutes the outermost semiconductor surface through the front face of the complete device.

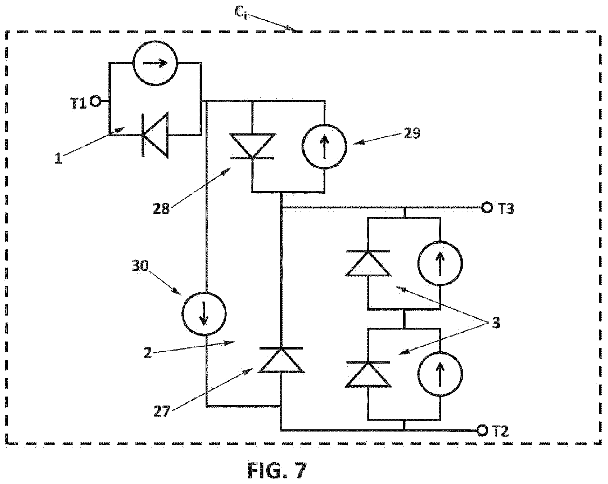

Figure 7 shows the equivalent electrical circuit linked to the second preferred embodiment of the photovoltaic cell Ci, depicted in figure 6. The visible sub-cell 2, which in this case is a cell with rear contacts with a floating emitter in the front face thereof, is shown at the electrical level with a total of four components: one rear pn junction diode 27, on which the voltage that is obtained between the second electrode T2 and the third electrode T3 is developed; a front diode 28 that represents the floating emitter 24 and wherein the majority of the photogenerated current is typically collected in the visible sub-cell 2, which is represented by means of a first current generator 29; and a second current generator 30 for transporting current between the two pn junctions. The collection of photogenerated current that is carried out directly on the rear surface and that can be represented by means of a current generator in parallel with a rear pn junction 27 has not been shown since, although it has a significant magnitude, the effect thereof is not relevant for the understanding of the operation of this structure.

This structure can benefit from the current collection improvements provided by the cells with rear contact, improved by collection on the front face and transportation to the rear face by means of Transistor Wrap Through (TWT). Said improvement is generally presented in WO 2006/051132 A1.

The present invention can likewise be implemented by means of only two semiconductor layers, which we shall continue to refer to as ultraviolet sub-cell 1 and visible sub-cell 2 for consistency, although the absorption ranges thereof may by modified with respect to the previous cases in order to suitably cover the solar spectrum.

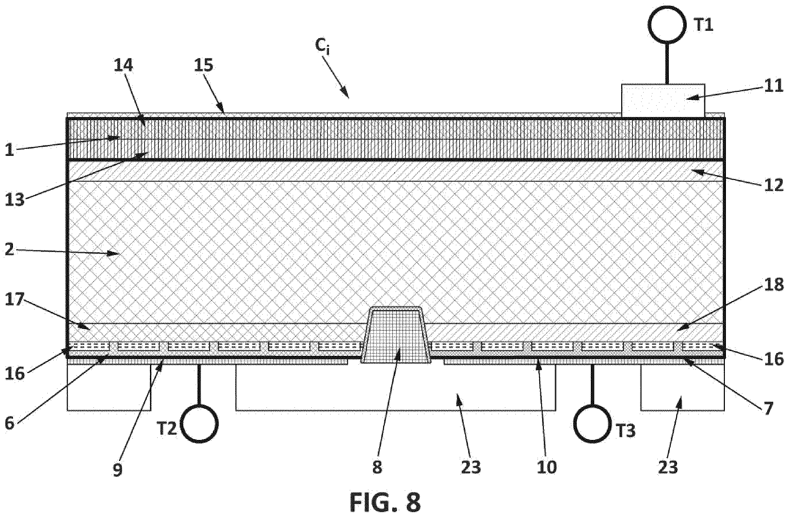

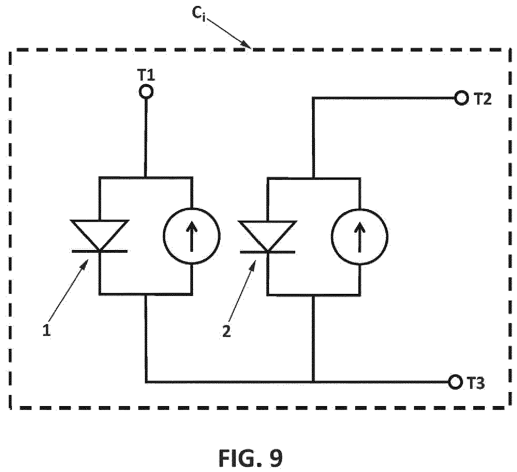

Figure 8 shows a third preferred implementation of the solar cell of the invention, equivalent to the configuration of the first preferred implementation shown in figure 4, but without infrared sub-cells 3. Figure 9 shows the equivalent electrical circuit of said third preferred implementation. Although the structure has an aspect with two opposite junctions or with bipolar transistor similar to others known in the state of the art, in this case the use of a silicon cell structure with rear contacts significantly simplifies the implementation and interconnection in the module of this device.

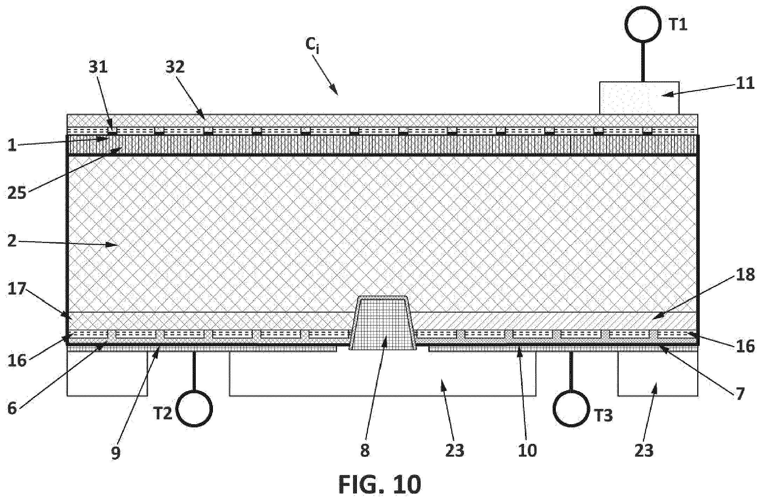

Similarly, figure 10 shows a fourth preferred implementation of the solar cell of the invention, equivalent to the configuration of the second preferred implementation shown in figure 6, but without infrared sub-cells 3. The visible sub-cell 2 has an n-type base region, and there is no p-type front diffusion, although this technologically appears in the implementation of the ultraviolet sub-cell 1. The rear face of the visible sub-cell 2 include positive and negative contacts (second electrode T2 and third electrode T3), carried out by means of the selective membranes by the aforementioned tunnel effect. The ultraviolet sub-cell is carried out by means of a central region 25 of a p-type doped, high band-gap width material, preferably with a gradual doping, more doped inside the device than at in the surface thereof. On the outer face of the central region 25 for absorbing and storing carriers, a selective membrane is carried out with respect to the carriers of interest, formed by a second selective membrane 31 with tunnel effect (a dielectric with a reduced thickness, typically 20 angstroms or less), and in the outer portion 32 a material is located, the extraction operation function of which is capable of extracting minority carriers from the central region 25 at the appropriate voltage. An excellent material is that which is a semiconductor, with a band-gap width that is sufficiently greater than that of the absorption material of the central region 25, such that significant reductions in the photogenerated current are not introduced, and also has a small resistance for the type of carriers extracted. Zinc oxide can be, for example, a suitable material for extracting electrons from a structure like the one proposed. In this way, the electrical contact may be located directly on this outer portion 32 without the need to add other additional ones that accommodate both materials.

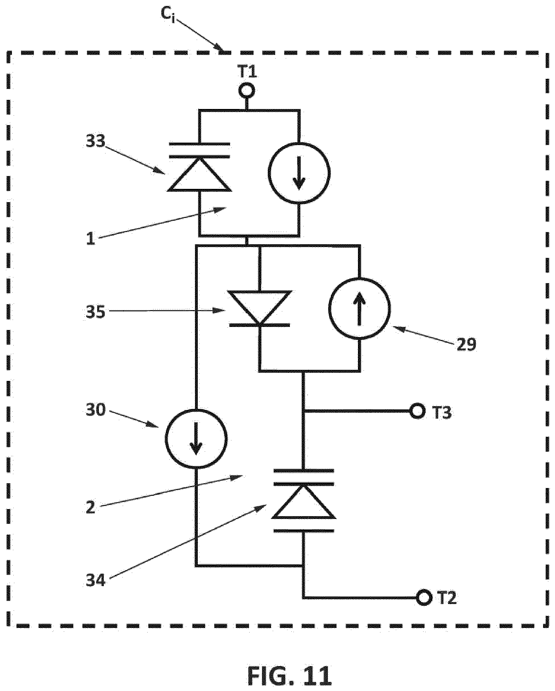

Figure 11 shows the equivalent electrical circuit of said fourth preferred implementation shown in figure 10. The diodes with a modified symbol, represent the selective membranes carried out in the device, with passage for only the electrons through the cathode 33 of the diode and with selective passages for electrons in cathodes and for holes in anodes 34. The diode 35 is not intentionally carried out, but appears in the manufacturing process of the ultraviolet sub-cell 1 as a pn junction on the front surface of the visible sub-cell 2.

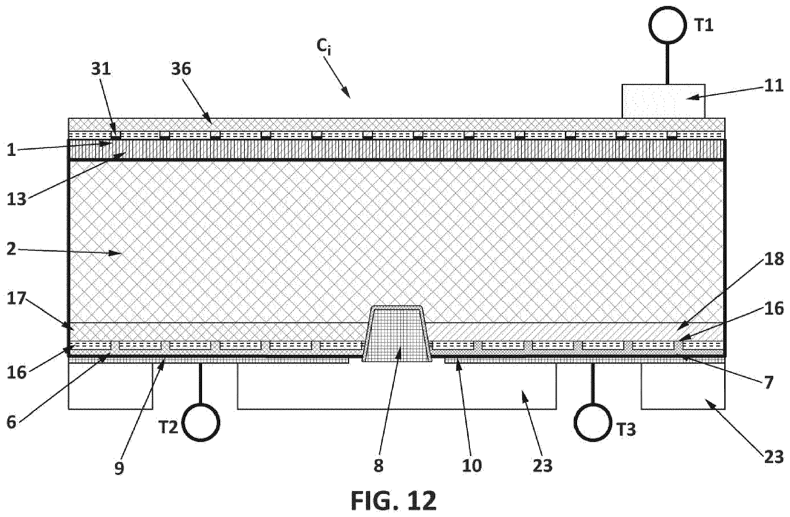

Figure 12 shows a fifth preferred implementation of the solar cell of the invention, also without infrared sub-cells 3, and dual to the fourth preferred implementation. High-energy holes are stored in the ultraviolet sub-cell 1, which are extracted through the second selective membrane 31 of tunnel effect towards an additional material 36 capable of incorporating them into the electrical circuit. To do so, the ultraviolet sub-cell 1 is constituted by an n-type semiconductor with a high band-gap width. The passivating properties of this n-type layer with respect to the front surface of the visible sub-cell 2 enable the passivating layer 12 on the front surface of the visible sub-cell 2 to be dispensed with.

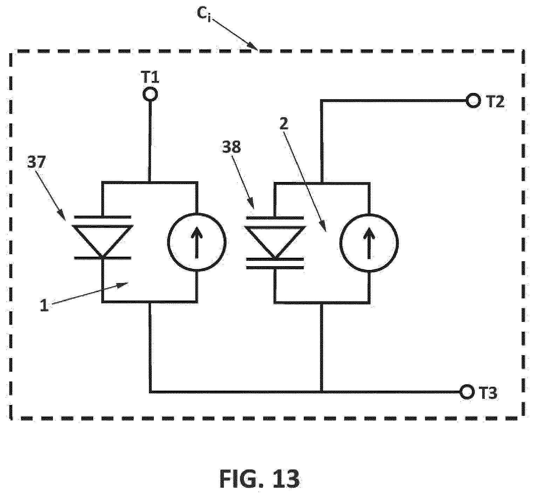

Figure 13 shows the equivalent electrical circuit of said fifth preferred implementation. In this case, the two pn junctions induced through the tunnel oxide are shown, both in the ultraviolet sub-cell, in this case only in the anode 37 thereof, and in both terminals 38 of the visible sub-cell.

It must be noted that in the case of keeping the infrared sub-cells 3 and removing the ultraviolet sub-cell 1, a configuration similar to that presented in EP 2490267 A2 could be reached. The improvements and characteristics of the particular implementations described in EP 2490267 A2 may therefore be applied to particular implementations of the infrared sub-cells 3 and to the visible sub-cell 2 of the present invention, even in the presence of the ultraviolet sub-cell 1.

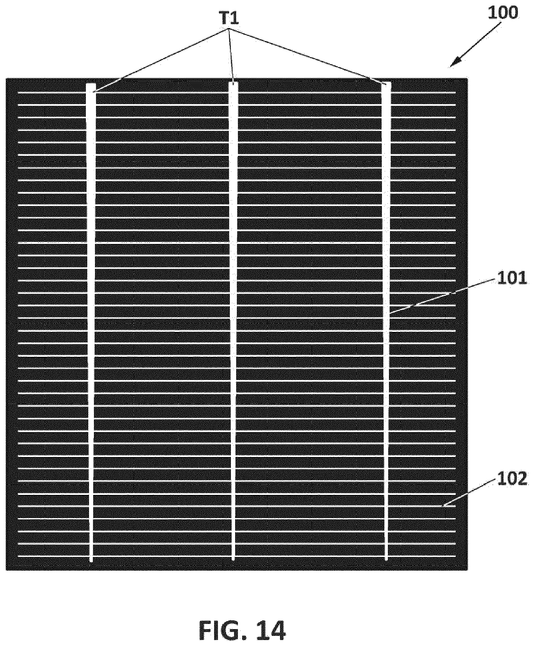

Figure 14 shows a possible implementation of the front face of a photovoltaic solar cell 100, Cᵢ, according to any of the described implementations. The photovoltaic panel 100 comprises one or several bus-bars 101, on which a grate with metal fingers 102 that are parallel to each other and perpendicular to the bus-bars 101 is located, in a comb shape as usual in industrial solar cells. The metal fingers 102 and the bus-bars 101 correspond to the first electrode T1 of the photovoltaic cell Cᵢ.

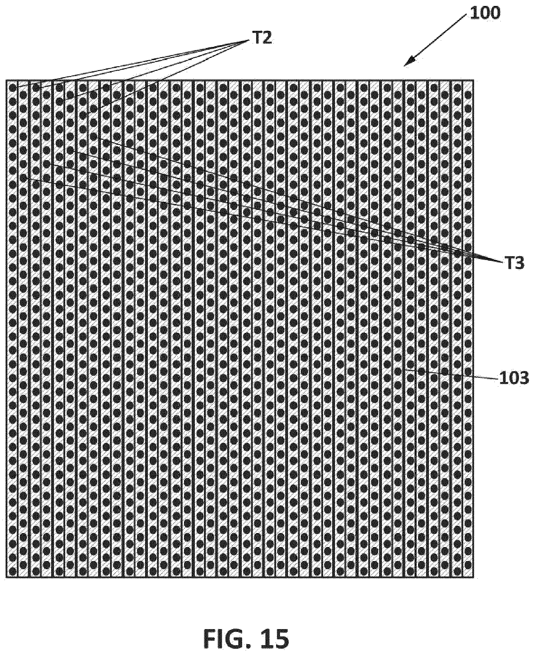

Figure 15 shows a possible implementation of the rear face of a photovoltaic solar cell 100, Cᵢ, according to any of the described implementations. The second electrodes T2 and the third electrodes T3 are connected in alternate parallel lines 103.

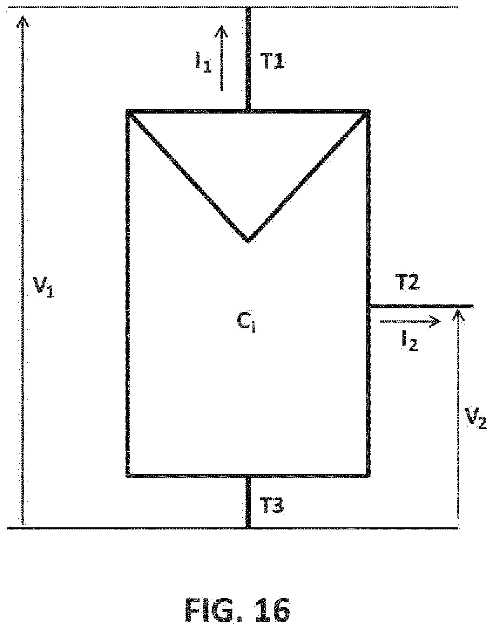

Figure 16 shows the diagram used in the present description in order to represent a photovoltaic cell Cᵢ. The third electrode T3 is considered to be a common terminal, with respect to which two different electrical circuits can be connected depending on the use of the first electrode T1 or the second electrode T2 as a remaining terminal. Although, as has been noted above, depending on the implementation carried out, the common terminal may be T2 instead of T3. We shall refer to the current extracted through the first electrode T1 as I₁, the current extracted through the second electrode T2 as I₂, the voltage between the first electrode T1 and the third electrode T3 as V₁, and the voltage between the second electrode T2 and the third electrode T3 as V₂.

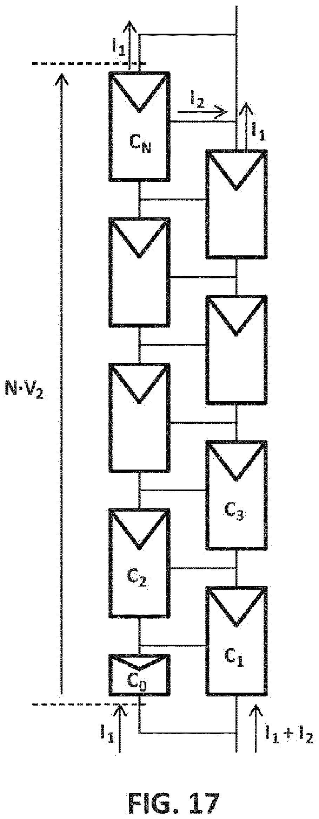

Figure 17 shows a connection circuit of multiple photovoltaic cells Cᵢ in accordance with a preferred embodiment of the solar panel 100 of the invention. The circuit comprises N+1 cells, a final voltage of NxV₂ and a current of 2xI₁ + I₂ being obtained. For the interconnection of the photovoltaic cells Cᵢ, it is proposed that two conducting planes be carried out. The termination of a module composed of N+1 cells, as shown herein, requires the inclusion of an extra cell C₀ that operates at the voltage V₂ but that only provides the current I₁. To do so, an additional cell with a smaller area may be used or the extra cell C₀ may be integrated into a first cell C₁ with a greater area.

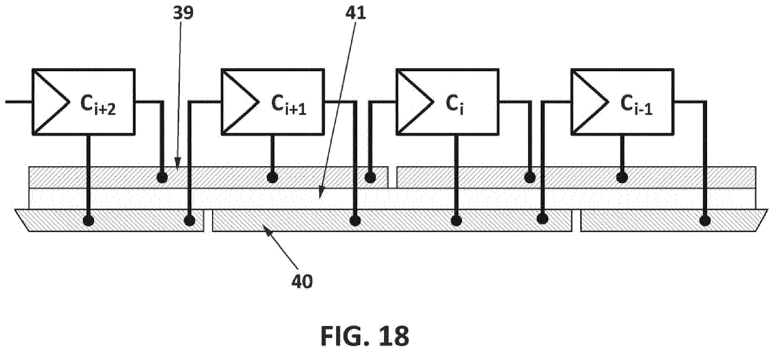

Figure 18 shows a possible diagram of interconnection of the photovoltaic cells Cᵢ on two conducting planes: an upper plane 39 and a lower plane 40. Each plane is formed by tiles of an electrical conductor, the size of which encompasses the size of two consecutive cells, both in the upper plane 39 and the lower plane 40. The two conducting planes are separated by a dielectric 41. For a specific cell Cₖ, the upper tile encompasses at least partially the area of said cell Cₖ, as well as the area of the next cell Cₖ₊₁ or the previous cell Cₖ₋₁ in the electrical circuit. On the other hand, the lower tile partially encompasses the area of the cell Cₖ as well as the complete area corresponding to the opposite cell to that of the upper tile (the next cell Cₖ₊₁ or the previous cell Cₖ₋₁). The three terminals of each cell Cₖ are connected to these tiles in an alternative manner. The third electrode T3 is always connected to the tile that is directed towards the previous cell Cₖ₋₁, while the second electrode T2 is connected to that which is directed towards the next cell Cₖ₋₁. Lastly, the first electrode T1 is connected to the tile that comes from the next cell Cₖ₊₁ but that encompasses the area of the Cₖ cell.

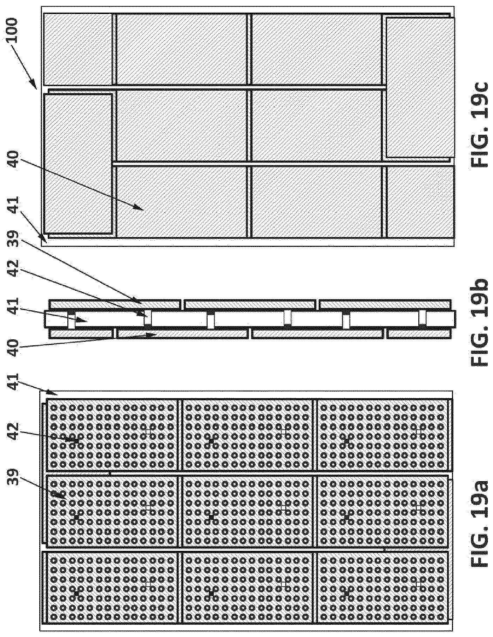

Figures 19a, 19b and 19c respectively show a front view, a side view and a rear view of the conducting planes 39, 40 described. In this configuration, the currents that pass through each photovoltaic cell Cₖ is mostly transverse to the structure thereof, and the length said currents travel is to the order of the thickness of the photovoltaic cell Cₖ, consequently the series resistance associated to the photovoltaic cell Cₖ is also very low. In the case where copper is used as a material for the tiles, thicknesses of 15 micrometers are sufficient to transport the current in cells up to an area of 250 cm² without significant resistive losses.

In the realization process of the laminate of the conducting planes 39, 40, diodes 42 may be included between the two conducting layers, connecting the anode to the negative terminal of the cell to be located in this position and the cathode on the opposite surface, such that the diodes 42 are in an antiparallel position with respect to the cell, constituting an efficient protection against the lack of uniformity in the illumination of the module.

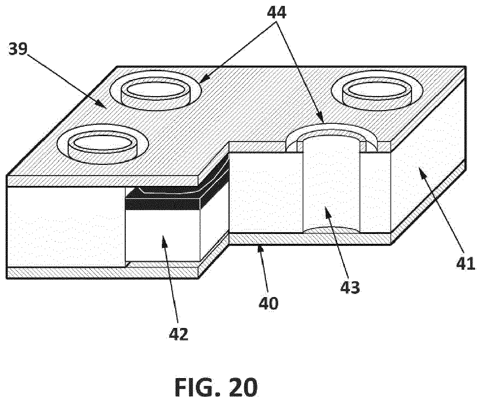

Figure 20 shows the connection of each cell of each level of the electrical circuit, upper or lower. To do so, interconnection openings 43 are carried out that enable the lower level to be accessed from the upper level. A protective ring 44 around each interconnection opening 43 is recommended in order to prevent the excess conducting adhesive used in the interconnection of the terminals of the cell to the lower level from short circuiting both conducting planes.

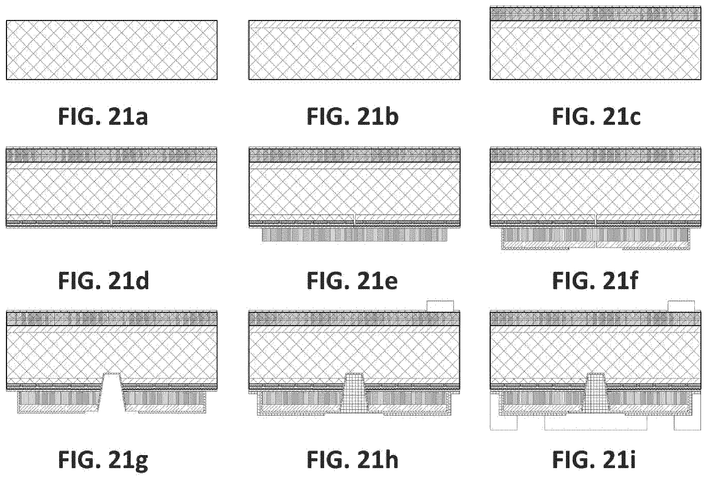

Lastly, figure 21 shows a particular embodiment of the manufacturing process of the photovoltaic cells of the invention with three levels and two sub-cells in the lower level. A person skilled in the art will understand that the process can be simply adapted (changing materials, doping, deposition order, engraving structures, etc.) in order to implement the multiple variants of photovoltaic cells described without departing from the object of the invention as it has been claimed.

Figure 21a shows a crystalline silicon sheet that serves as a support for the rest of the device. The crystalline silicon sheet may be textured on the front face thereof in order to reduce the reflection of the incident light. The sheet is gently diffused in a phosphorus environment on the front face thereof, as may be seen in figure 21b, a spread n-type region being obtained, according to any of the strategies known in the state of the art for said purpose. For example, the entire surface of the semiconductor can be diffused and subsequently the spread regions are removed from both the rear face of the device and the side surfaces thereof. It can also be selectively diffused only on the front surface, using masking agents of the diffusion of the remaining structure o covering the front surface with a precursor of the dopant material and then subjecting the material to a sufficient temperature. Said front diffusion can also not be carried out and it appears throughout the different thermal processes to which the device is subjected based on the dopant contained in the next layer of the semiconductor material that is deposited on the front surface thereof.

Figure 21c shows the deposition by means of chemical vapor deposition (CVD) of the large band-gap width that forms the ultraviolet sub-cell 1. Said material of large band-gap width is of the same electronic type as that which is used in the surface of the visible sub-cell, all the variants described in the particular embodiments of the cell being considered. The material to be deposited can be crystalline silicon carbide, gallium phosphide or another that presents a width of the band-gap thereof with at least 1.5 eV when the visible sub-cell 2 is of crystalline silicon. The doping of this layer can be varied, being more doped in the interface of the visible sub-cell that gradually moves further from the same and finally inverted, of n-type to p-type or vice versa, and close to the surface of the material. This layer may also be finalized without inverting the polarity of the material, growing a final oxide layer capable of being passes through by tunnel effect and then depositing a transparent conducting layer.

Figure 21d shows the manufacture of the visible sub-cell 2 until it is finished in the p-type and n-type emitters thereof or in the polysilicon layers, for which reason the current is extracted from said visible sub-cell 2. It must be noted that this process does not include any metallization step or carrying out electrical contacts.

Figure 21e shows the deposition on the rear portion of the visible sub-cell 2 of the material of small band-gap width of the infrared sub-cell 3, such as, for example, silicon-germanium with a variable proportion in order to adjust the width of the band-gap. This deposit may be grown by CVD by making silane and germane gases react, although it can also be substituted by sources based on organometallic germanium. The deposition of the material of silicon-germanium may be selective on the rear surface of the visible sub-cell 2, for which reason the rear surface of polysilicon of the cell may be partially oxidized. A layer with wider band-gap width is deposited on this layer in order for it to be a rear emitter. The deposition of this material with wider band-gap width may be carried out from the same type on both the regions of the p⁺ electrodes 6 and the n⁺ electrode 7 and subsequently be p-type or n-type doped on the surface thereof by means of a selective technique such as printing material containing dopant on each region either by screen printing or by inkjet, followed by a thermal process to introduce and redistribute these impurities in the material with wider band-gap width. A suitable material for this purpose can be silicon deposited at intermediate temperatures, between 400 and 600 °C based on a silane source, SiH₄, or another traditional source such as chlorosilane or dichlorosilane. The silicon can be deposited in the form of polycrystals with a grain size of several micrometers, sufficient so that each grain contacts the material of low band-gap width and the outside of the solar cell. Then, the deposited layers are covered with an electrical insulator, which can be SiO₂ obtained by means of a simple oxidation of the deposited polysilicon. Figure 21f shows the structure resulting from these processes.

Subsequently, all the layers that cover the non-regrown areas of the emitters of the p⁺ electrode 6 and the n⁺ electrode 7 must be removed. An option can be for a window to these emitters to be opened, either by means of selective attacks carried out by screen printing, laser ablation or other similar techniques. Windows also open in regions close to the p-type and n-type polysilicon layer. The resulting structure is represented in figure 21g.

Subsequently, metal is deposited on the entire rear surface of the cell and it is removed in certain areas in order to prevent short circuits between the second electrode T2, the third electrode T3 and the connection 8 of the infrared sub-cells 3. There are several ways to carry out this circuit with three rear electrical regions: either printing it by screen printing or another similar technique; either depositing the metal on the entire rear surface and then removing the excess by means of chemical attacks or laser ablation; or depositing it in two steps and using masking agents in each one of them. In a process prior or subsequent to the subsequent metallization, the anti-reflective layer is deposited on the front surface and the metallization of said front face is carried out, typically in the form of a metal grate. Figure 21h shows the structure after these steps. Lastly, an electrical insulator may be deposited, preferably by screen printing on the lower face of the cell such that only the electrical connection points to the external circuit of the solar cell are uncovered, reaching the final cell of figure 21i.

For the electrical connection of the entire module, a laminate with two metal conducting layers is provided with a thickness between 10 and 50 micron, which is drilled in the upper face thereof leaving a connection route of the lower face from the upper face. Around the interconnection openings 43 with the lower face, a protective ring 44 of the metal of the front face may be left in order to prevent short circuits in the assembly For the constitution of the circuit, a conducting adhesive is applied on the electrical contacts and a non-conducting adhesive is applied on the remaining regions, which can be done by screen printing either on the front face of the bimetal laminate or on the rear surface of the cell. This second option is preferred since the size of the cells facilitates the handling thereof in the screen printing. Lastly, the front contact (first electrode T1) is applied, which contacts a specially prepared area of the bimetal laminate and that, depending on the position of the cell, gives access to the front or rear face. Lastly, the entire previously constituted electrical circuit is laminated between layers of glass or another transparent material and a tedlar-type weather insulation or equivalent for the rear face, which concludes the manufacturing of the module.

In view of this description and Figures, the person skilled in the art will understand that the invention has been described according to preferred embodiments thereof, but that multiple variations can be introduced in said preferred embodiments without departing from the object of the invention as has been claimed.

In this text the word "comprises" and its derivations (such as "comprising", etc.) should not be understood in an excluding sense, that is, these terms should not be interpreted as excluding the possibility that what is described and defined may not also include further elements, steps, etc.

## Claims

1. Photovoltaic cell (Cᵢ) comprising at least one sub-cell of a first semiconductor (1) and a sub-cell of a second semiconductor (2), the sub-cell of the first semiconductor (1) being closer to a surface of incidence of electromagnetic radiation than the sub-cell of the second semiconductor (2) and the first semiconductor having a wider band-gap width than the second semiconductor, **characterized in that** it comprises:
- a first electrode (T1) connected to the sub-cell of the first semiconductor (1) at an end opposite a first interface between the first semiconductor and the second semiconductor, both sides of the first interface comprising the same type of majority carriers;
- a second electrode (T2) connected to the sub-cell of the first semiconductor (1) and to the sub-cell of the second semiconductor (2), the second electrode (T2) being accessible from an end opposite the surface of incidence of electromagnetic radiation;
- a third electrode (T3) connected to the sub-cell of the second semiconductor (2) and accessible from the end opposite the surface of incidence of electromagnetic radiation.

2. Photovoltaic cell (Cᵢ) according to claim 1, **characterized in that** the second semiconductor is crystalline silicon.

3. Photovoltaic cell (Cᵢ) according to any of the preceding claims, **characterized in that** it further comprises at least two sub-cells of a third semiconductor (3) with a narrower band-gap width than the second semiconductor, the at least two sub-cells of a third semiconductor (3) being connected in series to the second electrode (T2) and the third electrode (T3); and the at least two sub-cells of a third semiconductor (3) being connected to the sub-cell of the second semiconductor (2) through a second interface opposite the first interface, both sides of the second interface comprising the same type of majority carriers.

4. Photovoltaic cell (Cᵢ) according to any of the preceding claims, **characterized in that** the voltage between the first electrode (T1) and the second electrode (T2) has the same magnitude and opposite sign as the voltage between the third electrode (T3) and the second electrode (T2).

5. Photovoltaic cell (Cᵢ) according to any of claims 1 to 4, **characterized in that** the voltage between the first electrode (T1) and the second electrode (T2) has the same sign and twice the magnitude of the voltage between the third electrode (T3) and the second electrode (T2).

6. Photovoltaic cell (Cᵢ) according to any of the preceding claims, **characterized in that** it further comprises at least one selective membrane (16, 31) with transportation by tunnel effect.

7. Photovoltaic cell (Cᵢ) according to any of the preceding claims, **characterized in that** it further comprises at least one passivating layer (12).

8. Photovoltaic cell (Cᵢ) according to any of the preceding claims, **characterized in that** it further comprises at least one conducting layer (15).

9. Photovoltaic cell (Cᵢ) according to any of the preceding claims, **characterized in that** it further comprises at least one floating emitter (24).

10. Photovoltaic panel (100) **characterized in that** it comprises a plurality of photovoltaic cells (Cᵢ) according to any of claims 1 to 9.

11. Photovoltaic panel (100) according to claim 10, **characterized in that** the voltage between the first electrode (T1) and the third electrode (T3) of each photovoltaic cell or reference electrode (Cᵢ) has the same sign and twice the magnitude of the voltage between the second electrode (T2) and the third electrode (T3); and **in that** the second electrode (T2) of each cell (Cᵢ) is connected to the first electrode (T1) of an adjacent first cell (Cᵢ₋₁) and to the third electrode (T3) of an adjacent second cell (Cᵢ₊₁).

12. Photovoltaic panel (100) according to claim 11, **characterized in that** it comprises two conducting layers (39, 40) separated by an insulating layer (41).

13. Photovoltaic panel (100) according to claim 12, **characterized in that** the two conducting layers (39, 40) comprise a plurality of tiles, each tile at least partially covering a surface occupied by two adjacent cells.

14. Manufacturing method of photovoltaic cells (Cᵢ) comprising growing in a crystalline form at least one sub-cell of a first semiconductor (1) on a sub-cell of a second semiconductor (2), the first semiconductor being closer to a surface of incidence of electromagnetic radiation than the second semiconductor and the first semiconductor having a wider band-gap width than the second semiconductor, **characterized in that** it comprises forming:
- a first electrode (T1) connected to the sub-cell of the first semiconductor (1) at an end opposite a first interface between the first semiconductor and the second semiconductor, both sides of the first interface comprising the same type of majority carriers;
- a second electrode (T2) connected to the sub-cell of the second semiconductor (2) and accessible from the end opposite the surface of incidence of electromagnetic radiation; and
- a third electrode (T3) connected to the sub-cell of the first semiconductor (1) and to the sub-cell of the second semiconductor (2), the second electrode (T2) being accessible from an end opposite the surface of incidence of electromagnetic radiation.

15. Manufacturing method according to claim 14, **characterized in that** it further comprises growing in a crystalline form, on the sub-cell of the second semiconductor (2), two sub-cells of a third semiconductor (3) with a narrower band-gap width than the second semiconductor, the at least two sub-cells of the third semiconductor (3) being connected in series to the second electrode (T2) and to the third electrode (T3); and the at least two sub-cells of a third semiconductor (3) being connected to the sub-cell of the second semiconductor (2) through a second interface opposite the first interface, both sides of the second interface comprising a same type of majority carriers.
